# EUROPEAN PATENT APPLICATION

(11) **EP 0 605 994 A1**
(43) Date of publication of application: **13.07.1994**
(21) Application number: 93310348.3
(22) Date of filing: 20.12.1993
(51) Int. Cl.: H01L 31/048

(54) **Process for encapsulating photovoltaic cells in laminated glazings**

(30) Priority: 08.01.1993 US 1963
(71) Applicant: FORD MOTOR COMPANY, Dearborn, MI 48126 (US)
(72) Inventor: Gajewski, Kenneth Joseph, Woodhaven, Michigan 48183 (US); Kelly, Timothy Lee, Ann Arbor, Michigan 48104 (US)
(74) Representative: Messulam, Alec Moses

(57) **Abstract**

A process for encapsulating photovoltaic cells within a laminated glazing includes attaching the cells to the interlayer material by applying a solvent to portions of the interlayer to tackify the interlayer, and thereafter applying the photovoltaic cells thereto.

## Description

This invention relates generally to a method for encapsulating photovoltaic cells in laminated glazings. More particularly, the invention is directed to a process for attaching one or an array of photovoltaic cells to an interlayer lamina in a manner which does not destroy the textured surface thereof so that the assemblage may be properly degassed during the lamination process.

The lamination of sheets of glass and interposed layers of polymeric materials to produce glass laminates, e.g., windshields, is well known. Recently, there have been attempts to encapsulate photovoltaic cells along with polymeric interlayer materials between glass sheets, to produce motor vehicle vision glazings which additionally provide electrical energy for certain vehicle systems such as, for example, ventilation fans which cool the interior of the motor vehicle while it is parked in the hot sunlight. Photovoltaic cells may conveniently be placed in registry with the shade band of a windshield, or around the periphery of other automotive glazings, including sunroof glazings, to conceal their presence.

Since photovoltaic cells generally comprise somewhat brittle or otherwise fragile semi-conductive disks or wafers of mono- or polycrystalline metals and metaloids, they require protection against damage caused by mechanical deformation and exposure to corrosive atmospheres. Encapsulation within a motor vehicle laminated glazing affords the necessary protection, yet allows unhindered exposure to sunlight. Nevertheless, there are manufacturing difficulties associated with the insertion of photovoltaic cells into a laminated glazing structure.

Windshields, for example, are typically produced by first preshaping two curved glass sheets, and thereafter interposing a layer or layers of polymeric materials therebetween. This assembly is then subjected to heat and pressure, to effectively laminate the individual components into a unitary windshield. Generally, a monolithic polymeric interlayer having a gradient shade band is placed onto an apposing surface of one of the curved glass sheets, the mating glass sheet is superimposed over the interlayer material, and the assembly is prelaminated by conveying it through a series of heaters and rolls which press the assembly together while expelling air and other gases from between the laminae or by utilizing a peripheral evacuation gasket. As a final process step, the assembly is degassed and laminated utilizing elevated temperatures and pressures in an autoclave.

Polyvinyl butyral is typically used as the polymeric interlayer material in modern motor vehicle laminated glazings. Recently, other polymeric materials having been developed, which can be used alone or in combination with polyvinyl butyral. Such materials include polyvinyl chloride, polyesters, polyurethanes, polyolefins, and copolymers of ethylene and vinyl acetate. The major surfaces of such interlayer materials, however, must be textured or patterned to provide passageways for the elimination of entrapped air and gases to the edge of the assembly during the lamination process. The textured surface itself is eliminated by the high pressures and temperatures that are applied to the assembly during the prelaminating and autoclaving operations. If polymeric interlayer materials having smooth major surfaces, or having partially textured surfaces which are interrupted by smooth portions, are used, air and/or gas bubbles become entrapped during the lamination process thereby ruining the ultimately produced laminated glazing.

Where photovoltaic cells are to be encapsulated along with the polymeric interlayer, the cells must be attached to the interlayer lamina to maintain registry with the interlayer so that the photovoltaic cells appear in the proper location within the ultimately produced laminated glazing. For example, photovoltaic cells encapsulated in a motor vehicle windshield must be located outside of the field of view as mandated by federal regulations, such as at a location within the shade band or along the cowl of the windshield.

The conventional method for attaching photovoltaic cells to a polymeric interlayer lamina is to thermally bond the cells to the interlayer, by heating the cells and pressing them against the interlayer lamina, or by heating the cells and pressing them between two interlayer laminae. However, this destroys the pattern on the opposite major surface of the interlayer or interlayers, causing the formation of bubbles during the subsequent lamination process.

U.S. Patent No. 4,636,578 to Feinberg discloses a process for encapsulating photovoltaic cells in a laminated glazing. The process includes laying-up the assembly by inserting a first sheet of interlayer material between glass sheets, positioning an array of photovoltaic cells on the interlayer, then placing a second sheet of interlayer material over the first. This operation would not destroy the textured surfaces of either of the interlayer plys, but would allow the shifting of the photovoltaic cell array during subsequent handling and laminating operations because the cells are not attached in any way to either of the interlayer laminae. This could result in misplaced photovoltaic cells within the ultimately produced laminated glazing and, therefore, an unusable product.

U.S. Patent No. 4,321,418 to Dran et al. discloses a process for manufacturing laminated glazings containing photovoltaic cells, wherein the cells are imbedded in particulate thermoplastic resin between glass sheets and the entire assembly is laminated. However, it is difficult to provide an even layer of interlayer material in the ultimately produced product utilizing this process. Moreover, the exact placement of the photovoltaic cells within the polymeric powder requires precise manufacturing techniques, yet does not insure proper registry within the laminated glazing.

It would be desirable to encapsulate photovoltaic cells within a laminated glazing, by a process which includes a method for attaching the cells to a textured polymeric interlayer lamina in a manner which would not destroy the texture on the major surface of the interlayer opposite the surface to which the cells are attached. Such a process would insure proper placement of the photovoltaic cells within the ultimately produced laminated glazing without the formation of entrapped gas bubbles.

According to the present invention, a process for encapsulating photovoltaic cells within a laminated glazing surprisingly has been discovered. The process comprises the steps of:
A) providing a polymeric interlayer lamina;
B) tackifying a portion of a major surface of the polymeric interlayer lamina, by applying a solvent to said portion;
C) adhering a photovoltaic cell to the tackified portion of the surface of the polymeric interlayer lamina;
D) interposing the polymeric interlayer lamina having the photovoltaic cell adhered thereto intermediate two sheets of glass; and
E) laminating the glass sheets and lamina, thereby encapsulating the photovoltaic cell within the laminated glazing.

The process of the present invention is particularly well suited for preparing automotive and architectural laminated glazings.

This invention is directed to a process for encapsulating photovoltaic cells within a laminated glazing, by a process including the step of attaching the cells to an interlayer lamina without destroying the textured surface of the lamina so that the cells will maintain registry with their intended location in the ultimately produced glazing without the formation of gas bubbles during handling and laminating operations.

Any of the commonly known polymeric interlayer materials may be used to form the lamina of the present invention including, but not necessarily limited to, polyvinyl butyral, copolymers of ethylene and vinyl acetate, polyvinyl chlorides, polyesters, polyurethanes, polyolefins, and blends, copolymers, and laminates thereof. The polymeric materials may furthermore contain conventional polymer adjuvants such as, for example, plasticizers, fillers, stabilizers, dyes, pigments, ultraviolet light absorbers, and the like. The number of interlayer laminae and their materials of construction will, of course, be determined by the performance characteristics desired for the ultimately produced laminated glazing. A particularly preferred polymeric interlayer lamina material comprises polyvinyl butyral. The polymeric interlayer lamina according to the present invention is textured on its major surfaces for ease of handling and insertion between glass sheets during a subsequent lamination process and to facilitate degassing during the laminating and autoclaving steps.

A portion of one of the major surfaces of the polymeric interlayer lamina is tackified by contacting the surface with a solvent. The portion to be tackified is that area of the surface of the polymeric interlayer lamina to which photovoltaic cells are to be adhered. For example, where one intends to encapsulate photovoltaic cells in a motor vehicle windshield in registry with its shade band, the polymeric interlayer lamina is only tackified along the edge of the lamina which will ultimately correspond to the edge of the windshield having the shade band. The step of tackifying may be accomplished simply by placing a drop of a solvent on the polymeric interlayer lamina at each location where a photovoltaic cell is to be adhered to the lamina. The solvent softens and tackifies the polymeric interlayer lamina at the point of contact so that a photovoltaic cell placed thereagainst will adhere thereto as the solvent evaporates. Solvents which are useful for practising the present invention include, but are not necessarily limited to, alcohols such as isopropyl alcohol, acetone, benzene, methyl ethyl ketone, butyl ether, carbon tetrachloride, diethylene glycol, glycol, toluene, and the like, as well as mixtures thereof. A preferred solvent comprises an alcohol.

After selected portions of the polymeric interlayer lamina have been tackified, at least one photovoltaic cell is applied to the tackified portion. As the solvent evaporates, the photovoltaic cell adheres to the surface of the polymeric interlayer lamina. The major surface of the polymeric interlayer lamina opposite the surface to which the photovoltaic cell is attached remains unaffected. Typical photovoltaic cells useful for practising the present invention may be made from well-known materials such as, for example, mono- or polycrystalline silicon, gallium arsenide, and cadmium sulphide. The term "photovoltaic cell" also contemplates a plurality of cells combined into an array in series or parallel utilizing electrical connectors made from, for example, platinum, silver, or copper. Furthermore, the term "photovoltaic cell" contemplates other photo-activated devices such as, for example, photodetectors, photoconductors, photomultipliers, and the like. The amount of solvent applied to the surface of the polymeric interlayer lamina, as well as the conditions necessary for adhering the photovoltaic cell to the lamina, are not sharply critical and may be readily determined without undue experimentation by one ordinarily skilled in the art. Likewise, the dimensions of the tacked region between the polymeric interlayer lamina and the photovoltaic cell are a matter of choice which may be determined by routine experimentation depending upon the size and weight of the cell, the nature of the lamina and of the solvent, etc.

After the photovoltaic cell has been adhered to the polymeric interlayer lamina, the lamina carrying the photovoltaic cell is inserted intermediate two sheets of glass. Any type of glass generally known in the art as useful for preparing laminated glazings may be employed. Also contemplated by the term "glass" are semi-rigid plastics which are substantially transparent, e.g., polycarbonates, polyacrylics, polyesters, and the like. A particularly useful type of glass is a soda-lime-silica glass produced by the well-known float glass process. Moreover, one or more additional laminae of the same or a different polymeric interlayer material may be superimposed adjacent the lamina carrying the photovoltaic cells before insertion between the glass sheets. The glass sheets may be planar such as the glass sheets conventionally used to make architectural laminated glazings, or may be curved such as are used generally to prepare motor vehicle laminated glazings.

Procedures for laminating polymeric interlayer laminae between glass sheets are well known in the art. Generally, the interlayer lamina or assemblage of laminae is interposed between apposing surfaces of two mating superposed glass sheets and the entire structure is prelaminated by passing it between a series of prepressing rolls or by degassing the structure utilizing a peripheral evacuation gasket while at a temperature from about 150°F to about 300°F. This step removes most of the air and gases from between the lamina and glass sheets, facilitated by the textured surfaces of the lamina. The prelaminated structure is thereafter completely laminated in an oil or air autoclave under standard conditions including temperatures from about 200°F to about 300°F and simultaneous pressures from about 150 psi to about 300 psi for periods of time up to about two hours, depending upon the polymeric interlayer lamina materials of construction, the severity of curvature of the glass sheets, etc. The conditions for lamination may vary over wide limits and generally may be determined by routine experimentation by one ordinarily skilled in the art. Thus, the photovoltaic cell is encapsulated within the laminated glazing by a process which does not produce bubbles within the glazing during the lamination process.

## Claims

1. A process for encapsulating photovoltaic cells within a laminated glazing, comprising the steps of:
A) providing a polymeric interlayer lamina;
B) tackifying a portion of a major surface of the polymeric interlayer lamina, by applying a solvent to said portion;
C) adhering a photovoltaic cell to the tackified portion of the surface of the polymeric interlayer lamina;
D) interposing the polymeric interlayer lamina having the photovoltaic cell adhered thereto intermediate two sheets of glass; and
E) laminating the glass sheets and lamina, thereby encapsulating the photovoltaic cell within the laminated glazing.

2. A process for encapsulating photovoltaic cells according to Claim 1, wherein the polymeric interlayer lamina is prepared from a polymer selected from the group consisting of polyvinyl butyral, copolymers of ethylene and vinyl acetate, polyvinyl chlorides, polyesters, polyurethanes, polyolefins, and blends, copolymers, and laminates thereof.

3. The process for encapsulating photovoltaic cells according to Claim 1 or 2, wherein the solvent is selected from the group consisting of alcohols, acetone, benzene, methyl ethyl ketone, butyl ether, carbon tetrachloride, diethylene glycol, glycol, toluene, and mixtures thereof.

4. The process for encapsulating photovoltaic cells according to any one of claims 1 to 3, wherein, prior to step D, at least one additional polymeric interlayer lamina is superimposed between the glass sheets and adjacent the lamina provided in step A.

5. A process for encapsulating photovoltaic cells according to Claim 4, wherein the additional polymeric interlayer lamina is prepared from a polymer selected from the group consisting of polyvinyl butyral, copolymers of ethylene and vinyl acetate, polyvinyl chlorides, polyesters, polyurethanes, polyolefins, and blends, copolymers, and laminates thereof.

6. A process for encapsulating photovoltaic cells according to Claim 1, wherein the sheets of glass are planar.

7. The process for encapsulating photovoltaic cells according to anyone of the preceding claims, wherein the glass sheets are curved sheets of soda-lime-silica glass.

8. The process for encapsulating photovoltaic cells according to any one of the preceding claims, wherein the step of laminating includes prelaminating to remove air and gases from between the glass sheets.

9. A process for encapsulating photovoltaic cells according to any one of the preceding claims, wherein the laminating occurs at a temperature from about 200°F to about 300°F at a pressure form about 150 psi to about 300 psi.
